# EUROPEAN PATENT APPLICATION

(11) **EP 1 865 563 A2**
(43) Date of publication of application: **12.12.2007**
(21) Application number: 07010932.7
(22) Date of filing: 03.06.2007
(51) Int. Cl.: H01L 31/0224

(54) **Light assisted electro plating process**

(30) Priority: 05.06.2006 US 810954 P; 27.10.2006 US 588520
(71) Applicant: Rohm and Haas Electronic Materials, L.L.C., Marlborough, Massachusetts 01752 (US)
(72) Inventor: Allardyce, George R., Warwickshire CV11 6FH (GB); Bass, Kevin, Leicestershire LE11 3HX (GB); Rasch, Joachim, 73337 Bad Ueberkingen (DE)
(74) Representative: Buckley, Guy Julian

(57) **Abstract**

A method for light assisted electro plating of contacts for photosensitive devices especially solar cells is disclosed using a cyanid free bath.

## Description

The present invention relates generally to the field of metal plating. More particularly, the present invention relates to the field of metal plating of photovoltaic devices.

Photovoltaic devices, such as solar cells, often include a semiconductor wafer which forms a single large PN junction. Electromagnetic radiation such as sunlight incident upon that junction produces electrical carriers in the device and generates an electrical current, which must be collected and conveyed to an external circuit. The generated current is roughly proportional to the incident radiation. Metallic patterns which are in ohmic contact with the two sides of the PN junction collect the current. Such metallic patterns need to provide a low resistance path to minimize resistive losses of the generated current. The metallic pattern must be limited in its physical extent, especially on the front surface of the device, so as to minimize surface area that is blocks incident radiant energy, i.e. energy lost for current generation purposes. Typically, the front metallic pattern includes narrow strips of very highly conductive material.

In fabricating a flat plate silicon solar cell, a satisfactory metal pattern can be achieved by applying a thin patterned layer of an ohmic contact and barrier layer material and by subsequent metallization. One metallization approach is screen-printed silver paste, which provides a thick conductor of low enough resistance for many applications. The silver paste itself, however, is not of low enough resistance to provide optimum solar cell performance. A more conductive material such as plated silver or copper is needed to minimize resistive losses which lower the solar cell efficiency. Silver has been deposited electrolytically onto a photovoltaic device, where current has been generated in the device itself through the use of radiant energy. In such electrolytic silver plating process, uniform deposition of the silver layer is achieved when a voltage is applied to one surface of the device while simultaneously illuminating the opposite surface of the device with radiant energy.

Conventional silver electroplating baths used for such light assisted plating are cyanide-containing. However, the use of cyanide-containing plating baths raises numerous concerns, such as handling, waste treatment and environmental concerns. There is a desire in the industry for suitable plating baths for use in light assisted plating of photovoltaic devices where such plating baths are cyanide-free. U.S. Pat. No. 5,882,435 (Holdermann) discloses a process for the electroplating of solar cells made of crystalline silicon. This patent exemplifies the use of cyanide-containing silver plating baths. Although this patent does mention that cyanide-free silver plating baths may be used, it states that such cyanide-free silver baths have inadequate stability under the conditions of illumination.

Accordingly, there remains a need in the industry for suitable cyanide-free metal plating baths, particularly silver plating baths, that can be used in an electroplating process with illumination by radiant energy, and where such plating baths have sufficient stability under the conditions of use.

The present invention, which fills the above deficiencies, provides a method of plating an electrical contact on a light-sensitive device displaying a photovoltaic effect (a "photovoltaic device"), including providing a semiconductive wafer having at least two major surfaces, the wafer having a photovoltaic junction formed therein so that when one of the major surfaces of the wafer is exposed to light, negative charges collect at a first of the major surfaces and positive charges collect at a second of the major surfaces, contacting the wafer with a cyanide-free metal plating bath, applying a potential to the plating bath and exposing the wafer to light to deposit a layer of metal onto the first major surface, wherein the plating bath is an aqueous solution and includes metal ions, at least one water-soluble nitro-containing compound, at least one surfactant, at least one amido-compound, and at least one component chosen from a water-soluble amino acid, a water-soluble sulfonic acid, and mixtures thereof.

In another embodiment, a coating of a metal on the second major surface is provided prior to contacting wafer with the cyanide-free metal plating bath. In this embodiment, migration of the metal from the coating on the second major surface into the plating bath and thence to the negatively charged first major surface occurs.

The cyanide-free metal plating baths used in the present invention have sufficient stability under the conditions of illumination used in light assisted electroplating to provide metal deposits on photovoltaic devices that meet desired specifications.

Fig. 1 illustrates a photovoltaic device of the invention.

Fig. 2 is a schematic representation of providing a metal coating on a photovoltaic device according to the invention.

As used throughout this specification, the term "plating" refers to the deposition of a metal layer, such as by electroplating or electroless plating, as the context indicates. "Deposition" and "plating" are used interchangeably throughout this specification. The indefinite articles "a" and "an" are intended to include both the singular and the plural. The following abbreviations have the following meanings unless the context clearly indicates otherwise: °C = degrees Celsius; g = grams; mL = milliliter; L = liter; A = amperes; dm = decimeter; µm = micrometers; and nm = nanometers. All percentages and ratios are by weight unless otherwise indicated. All ranges are inclusive and combinable in any order except where it is clear that such numerical ranges are constrained to add up to 100%.

A wide variety of photovoltaic devices may be used in the present invention, such as, for example, solar cells. Such photovoltaic devices are typically produced using a semiconductor substrate, such as a semiconductor wafer. In one embodiment, solar cells are composed of monocrystalline or polycrystalline or amorphous silicon wafers. In another embodiment, solar cells are composed of polycrystalline silicon wafers. While the description below is with regard to silicon wafers, it will be appreciated by those skilled in the art that other suitable semiconductor wafers, such as gallium-arsenide, silicon-germanium, and germanium, may suitably be used with the present invention. When silicon wafers are used, they typically have a p-type base doping.

The wafers may be circular, square or rectangular in shape or may be any other suitable shape. Such wafers may have a wide variety of dimensions. For example, circular wafers may have a diameter of 150 nm, 200 nm, 300 nm, 400 nm, or greater.

The rear side of a wafer is metallized. The entire rear side may be metal coated or a portion of the rear side may be metal coated, such as to form a grid. Such rear side metallization may be provided by a variety of techniques, and may be done prior to the metallization of the front side of the wafer or may be done simultaneously with the metallization of the front side of the wafer. In one embodiment, a metal coating is applied to the rear side in the form of an electrically conductive paste, such as a silver-containing paste, an aluminum-containing paste or a silver and aluminum-containing paste. Such conductive pastes typically include conductive particles embedded in a glass matrix and an organic binder. Conductive pastes may be applied to the wafer by a variety of techniques, such as screen printing. After the paste is applied, it is fired to remove the organic binder. When a conductive paste containing aluminum is used, the aluminum partially diffuses into the rear side of the wafer, or if used in a paste also containing silver, may alloy with the silver. Use of such aluminum-containing paste may improve the resistive contact and provide a "p+"-doped region. Heavily doped "p+"-type regions by previous application of aluminum or boron with subsequent interdiffusion may also be produced. In one embodiment, an aluminum-containing paste may be applied to the rear side and fired before the application of the rear side metal coating. The residue from the fired aluminum-containing paste may optionally be removed prior to the application of the rear side metal coating. In an alternate embodiment, a seed layer may be deposited on the rear side of the wafer and a metal coating may be deposited on the seed layer by electroless or electrolytic plating. Such metal deposition on the seed layer on the rear side of the wafer may be performed simultaneously with the metal deposition on the front side of the wafer using the present invention.

The front side of the wafer may optionally be subjected to crystal-oriented texture etching in order to impart to the surface an improved light incidence geometry which reduces reflections. To produce the semiconductor junction, phosphorus diffusion or ion implantation takes place on the front side of the wafer to produce an n-doped region and providing the wafer with a PN junction.

A dielectric layer may optionally be added to the front side of the wafer. Such dielectric layer may serve as both a passivation layer and an antireflection layer. Suitable dielectric layers include, without limitation, silicon oxide layers such as SiOₓ, silicon nitride layers such as Si₃N₄, a combination of silicon oxide and silicon nitride layers, and a combination of a silicon oxide layer and/or a silicon nitride layer with a titanium oxide layer such as TiOₓ. In the foregoing formulae, x is the number of oxygen atoms. Such dielectric layer may be deposited by a number of techniques, such as by various vapor deposition methods.

The front side of a wafer typically contains a metallized pattern. For example, the front side of a wafer may be composed of current collecting lines and current busbars. Current collecting lines are typically transverse to the busbars and typically have a relatively fine-structure (i.e. dimensions) relative to current busbars.

In one embodiment, the front side of the wafer may be metallized using a conductive paste, which may be the same as or different from any conductive paste used on the rear side of the wafer. Any conductive paste used to metallize the front side of a wafer typically does not contain aluminum. The firing of any conductive paste used on the rear side and front side of a wafer may be performed in one operation or in separate operations. The temperature used in the firing of the paste will depend on the particular paste used, the thickness of any dielectric (or antireflective) layer used, among other factors. The choice of such temperature is well within the ability of those skilled in the art. Also, it will be appreciated by those skilled in the art that the firing process may be performed in an oxygen-containing atmosphere, an inert atmosphere, a reducing atmosphere, or a combination of any of these. For example, the firing may be performed at a first temperature in an atmosphere containing little oxygen and then at a second temperature under an inert atmosphere or under a reducing atmosphere, where the second temperature is higher than the first temperature.

Following the firing process, the wafer may optionally be contacted with a buffered acid solution, such as a buffered hydrofluoric acid solution, to remove any oxide produced during the firing procedure. Such contact may be by spraying the solution on the wafer or by dipping the wafer into such solution or by any other suitable means.

In another embodiment, the front side of the wafer is coated with an optional antireflective layer, such as silicon nitride. A trench pattern is then defined on the front side. The trench pattern reaches through the antireflective (or dielectric) layer and into the semiconductor body of the wafer. The trenches may reach a depth of 1 to 25 µm into the semiconductor body of the wafer. Deeper or shallower trench depths may be employed. A variety of processes may be used to form the trench pattern, such as, but not limited to, laser ablation, mechanical means, and lithographic processes, all of which are well known in the art. Such mechanical means include sawing and scratching. Typical photolithographic processes include disposing an imageable material on the surface of the wafer, patterning the imageable material to form trenches, transferring the trench pattern to the wafer, depositing a metal layer in the trench pattern and removing the imageable material. In one embodiment, the imageable material is removed before the step of depositing a metal layer in the trench pattern. In another embodiment, the imageable material is removed after the step of depositing a metal layer in the trench pattern. When the imageable material is present during the metal deposition step, such imageable material should avoid any dyes, such as contrast dyes, that absorb in the wavelength of radiation used during the metal deposition step. Imageable material present during the plating step should contain a dye that is transparent to the wavelength of radiation used during the plating step.

When the imageable material is a liquid, such material may be disposed on the surface of the wafer by any suitable technique such as, but not limited to, by spin coating, doctor blading, curtain coating, and roller coating. When the imageable material is a dry film, such material may be disposed on the surface of the wafer by lamination.

The imageable material is patterned by exposing the imageable material to actinic radiation through a mask. The choice of actinic radiation will depend upon the particular imageable material selected. Suitable wavelengths of actinic radiation include, but are not limited to, 500 nm to below 200 nm such as 430 nm, 405 nm, 365 nm, 248 nm, and 193 nm, as well as extreme ultraviolet ("EUV"), and e-beam. Lasers may also be used to pattern the imageable material.

The pattern in the imageable material is next transferred to the wafer substrate. Pattern transfer may be performed using wet chemical etching techniques or by using dry etching techniques. Suitable dry etching techniques include, without limitation, plasma etching such as reactive ion etching. The trench pattern typically is composed of lines of relatively narrow cross-sectional dimension which are current collecting lines and lines of relatively thick cross-sectional dimension which are busbars. The busbars are transverse to the current collecting lines.

The imageable material may be removed using any suitable polymer remover, such as those sold by Rohm and Haas Electronic Materials (Marlborough, Massachusetts). Such removers may be alkaline, acidic or essentially neutral.

Irrespective of the technique used to form the trench pattern, such trenches may optionally be contacted with acid (such as hydrofluoric acid) or alkali to texture or roughen the trench surfaces. Optionally, another diffusion process may be performed using an n-type dopant, resulting in "n++"-doping in the trench regions.

A conductive paste is typically deposited into the trenches in the front side of the wafer. The rear side of the wafer may be metallized before the front side, after the front side, or concurrently with the front side. When the rear side is metallized using a conductive paste, the front and rear sides are typically fired in a single step.

After the front side pattern and rear side of the wafer are metallized using conductive paste, a layer of metal is then deposited on the front side conductive pattern. Such layer of metal may be any suitably conductive metal such as gold, silver or copper, and is typically silver. In one embodiment, the deposited metal layer is composed of the same metal used in the conductive paste. For example, a silver layer is deposited on a silver-containing conductive paste.

The pattern containing a deposited metal layer, and particularly an electrodeposited metal layer, over a fired conductive paste has increased efficiency as compared to a pattern composed only of fired conductive paste. In addition, the use of a deposited metal layer over the fired conductive paste allows for a reduction in the width of both the current collecting lines and busbars, which provides more of the solar cell surface that can be exposed to incident light and therefore more current generation. Smaller metal lines means less metal on the surface to block the incident light.

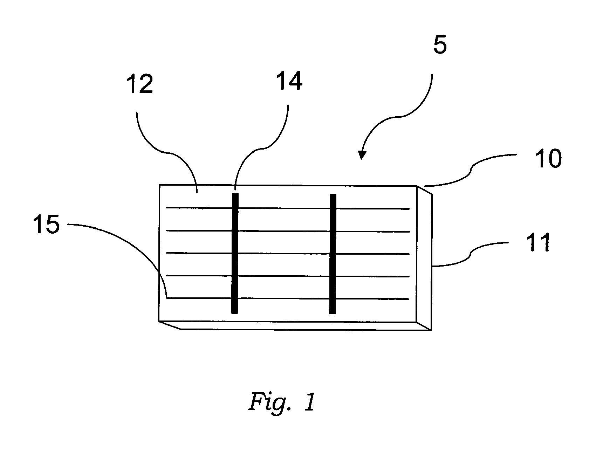

FIG. 1 illustrates a representative photovoltaic device **5** of the invention, such as a solar cell. Device **5** has a semiconductive wafer **10** having a PN junction and a rear side **11** and a front side **12**. Rear side **11** is metallized, such as with silver. Front side **12** contains a metallic pattern (such as a silver pattern) composed of busbars **14** and current collecting lines **15**. The metallic pattern is composed of a layer of deposited silver over a silver-containing conductive paste. The metallic pattern is in ohmic contact with front side **12**. Typically, front side **12** is covered with an antireflective coating, not shown, such as silicon nitride or other dielectric material.

The wafer is now ready to be plated with a layer of metal over the pattern on the front side and over the metallized rear side. In the present invention, a metal layer, and particularly a silver layer, is deposited on the fired conductive paste using a cyanide-free plating bath while subjecting the semiconductor wafer to incident light. The plating baths useful in the present invention are aqueous solutions and include metal ions, at least one water-soluble nitro-containing compound, at least one surfactant, at least one amido-compound, and at least one component chosen from a water-soluble amino acid, a water-soluble sulfonic acid, and mixtures thereof. Silver plating baths according to the present invention are available as ENLIGHT^{™} silver plate 600 from Rohm and Haas Electronic Materials, Marlborough, Massachusetts.

The metal ions in the present plating baths may be provided by using any suitable solution-soluble metal compound, typically a metal salt. Such metal compounds may include, without limitation: metal halides; metal nitrate; metal carboxylates such as acetate, metal formate and metal gluconate; metal-amino acid complexes such as metal-cysteine complexes; metal alkyl sulfonates such as metal methane sulfonate and metal ethane sulfonate; metal alkylol sulfonates, metal tolyl sulfonates, and metal phenol sulfonates. Exemplary metal compounds include copper compounds, gold compounds and silver compounds. In one embodiment, the metal compound is a silver compound. In particular, suitable metal compounds include silver nitrate, silver-cysteine complex, silver methane sulfonate, silver ethane sulfonate, silver propane sulfonate, silver phenol sulfonate, and silver acetate. It will be appreciated by those skilled in the art that when the metal is silver, the metal salt is typically not a silver halide due to the limited solubility of such salts. Mixtures of metal compounds may be used in the present plating baths. Such mixtures may be metal compounds having the same metal but being different compounds, such as a mixture of silver nitrate and silver-cysteine complex or metal compounds having different metals such as a mixture of silver-cysteine complex and copper gluconate. When different metal compounds having different metals are used in admixture, the present metal plating baths will deposit an alloy of the different metals.

The metal compounds are added to the plating bath in an amount sufficient to provide a metal ion concentration in the plating bath of 0.1 to 60 g/L, more typically from 0.5 to 50 g/L, and still more typically from 1 to 50 g/L. When the metal ions are silver ions, the concentration of silver ions in the bath is typically in an amount of 2 to 40 g/L. Such metal compounds are generally commercially available form a variety of sources, such as Aldrich chemical company, Milwaukee, Wisconsin.

The present metal plating baths are electroplating baths and contain an electrolyte. Any of a wide variety of electrolytes may be used in the present metal plating baths, including acids and bases. Exemplary electrolytes include, without limitation, alkane sulfonic acids such as methane sulfonic acid, ethane sulfonic acid and propane sulfonic acid; alkylol sulfonic acids; aryl sulfonic acids such as toluene sulfonic acid, phenyl sulfonic acid and phenol sulfonic acid; amino-containing sulfonic acids such as amido sulfonic acid; sulfamic acid; mineral acids; carboxylic acids such as formic acid and haloacetic acids; hydrogen halide acids; and pyrophosphate. It will be appreciated by those skilled in the art that salts of acids and bases may be used as the electrolyte. Further, the electrolyte may contain a mixture of acids, a mixture of bases or a mixture of one or more acids with one or more bases. Such electrolytes are generally commercially available form a variety of sources, such as Aldrich chemical company.

While not intending to be bound by theory, it is believed that the nitro-containing compounds in the present plating bath function to stabilize and complex the bath. Any of a wide variety of water-soluble nitro-containing may be used. Such nitro-containing compounds include, without limitation, nitro-containing carboxylic acids and their salts and nitro-containing sulfonic acids and their salts. Such nitro-containing compounds may contain one or more nitro-groups. The water-soluble nitro-containing compound typically has at least one heterocyclic group. In a further embodiment, the nitro-containing compound is an aromatic heterocyclic compound. Exemplary nitro-containing compounds include, without limitation, 2-nitrophthalic acid, 3-nitrophthalic acid, 4-nitrophthalic acid and/or m-nitrobenzene sulfonic acids. Typically, the nitro-containing compound is used in an amount of 0.1 to 200 g/L of the bath, and more typically 0.5 to 175 g/L and still more typically 1 to 150 g/L. Such nitro-containing compounds are generally commercially available form a variety of sources, such as Aldrich chemical company.

A wide variety of surfactants may be used in the present invention. Any of anionic, cationic, amphoteric and nonionic surfactants may be used. Exemplary nonionic surfactants include esters of succinic acid. In one embodiment, the surfactant is chosen from cationic and amphoteric surfactants. Exemplary cationic surfactants include, but are not limited to, 1,3-didecyl-2-methylimidazolium chloride available from Degussa under the trademark TEGOTAIN^{™}. In another embodiment, the surfactant is amphoteric, such as an alkylbetaine available from Degussa under the trademark TEGOTAIN^{™}. Mixtures of surfactants may be used. Such surfactants are typically present in the plating bath in an amount of 0.1 to 5 g/L.

Optionally, vitamins may be included in the present plating baths. They may be fat-soluble or water-soluble. Typically, a water-soluble vitamin is used. Suitable fat-soluble vitamins include A, D₁, D₂, D₃, K₁, K₂, and E. Suitable water-soluble vitamins include C, B₁, B₂, B₃, B₆ and B₁₂. Exemplary vitamins include, without limitation, retinol, sterols, ergocalciferol, cholecalciferol, phytonadione, multiprenylmenaquinone, α-tocopherol, β-tocopherol, ascorbic acid, thiamin, nicotinic acid, riboflavin, pantothenic acid, biotin, pyridoxine, folic acid and cyanocobalamin. Particularly suitable vitamins include ascorbic acid, thiamin, nicotinic acid, riboflavin, pantothenic acid, biotin, pyridoxine, and folic acid. As used herein, the term "vitamin" is intended to include the salts of vitamins.

In general, when vitamins are added to the baths, vitamins are present in the plating baths in amounts of 0.01 to 150 g/L, typically from 0.5 to 100 g/L and more typically from 1 to 100 g/L. Vitamins are generally commercially available from a variety of sources, such as Aldrich chemical company.

A wide variety of amido-compounds may be used in the present plating baths. Suitable amido-containing compounds include, without limitation, sulfonic acid amides such as succinic acid sulfamide and carboxylic acid amides such as succinic acid amide (succinamic acid).

In general, amido-compound is present in the plating baths in an amount of 0.01 to 150 g/L, typically from 0.5 to 100 g/L and more typically from 1 to 100 g/L. Amido-compounds are generally commercially available from a variety of sources, such as Aldrich chemical company. Additionally amido-compounds may be generated *in situ* from imides, such as, for example, succinimide. While not being bound by theory, imides added to the alkaline bath at bath temperatures convert to their corresponding amido-compounds. This is believed to occur through nucleophilic attack by hydroxyl ions (OH⁻) at a carbon-nitrogen bond (C-N) of the imide.

Any amino acid may suitably be used in the present plating baths, including derivatives of amino acids and salts of amino acids. The amino acids of the present invention may contain one or more mercapto groups in addition to one or more amino groups. Examples of suitable amino acids include, but are not limited to, glycine, alanine, cysteine, methionine and 4-amino-nicotinic acid. When an amino acid is used in the present plating baths it is used in an amount of 0.1 to 150 g/L, more typically from 0.5 to 150, and more typically from 0.5 to 125 g/L. Mixtures of amino acids may be used. Such metal compounds are generally commercially available form a variety of sources, such as Aldrich chemical company. When the metal is silver, the water-soluble amino acid compound is typically present in excess of the stoichiometric amount of silver.

A wide variety of water soluble sulfonic acids may be used in the present plating baths. Exemplary sulfonic acids include any of the sulfonic acids described above for the electrolyte. When a sulfonic acid is used as the electrolyte, no additional sulfonic acid is required. Typically, the sulfonic acid is present in an amount of 0.1 to 200 g/L.

Optionally, the present plating baths may contain one or more additional components. Such additional components include, without limitation, brighteners, grain refiners, ductility enhancers, anti-tarnish agents and anti-freeze agents. Sulfone-containing compounds may be used as brighteners. In particular, suitable sulfone-containing compounds contain one or two aromatic rings on the sulfone group. Such aromatic rings may optionally be substituted by one or more substituents chosen from nitro, amino, halo, alkyl, and metals. When present, the sulfone-containing compound is typically used in an amount of 0.001 to 5 g/L of the plating bath.

A wide variety of anti-tarnish agents may optionally be used in the present plating baths. Suitable anti-tarnish agents include, without limitation, triazoles, benzotriazoles, tetrazoles, imidazoles, benzimidazoles, and indazoles. Particularly useful anti-tarnish agents include (C₁-C₁₆)alkylimidazoles and arylimidazoles. Exemplary anti-tarnish agents include, but are not limited to, methylimidazole, ethylimidazole, propylimidazole, hexylimidazole, decylimidazole, undecylimidazole, 1-phenylimidazole, 4-phenylimidazole, hydroxybenzotriazole, aminobenzotriazole, 2-imidazolecarboxaldehyde, benzotriazolecarboxylic acid, 2-guanidinobenzimidazole, 2-aminoindazole, chlorobenzotriazole, hydroxyethylbenzotriazole, hydroxyethylimidazole, hydroxybenzimidazole and 1,2,4-triazole. Mixtures of anti-tarnish may be advantageously used in the present plating baths. In general, when an anti-tarnish agent is used, it is present in an amount from 0.005 to 50 g/L.

In a further embodiment, the metal plating bath may optionally contain a buffering agent. Exemplary buffering agents include, but are not limited to, borate buffer (such as borax), phosphate buffer, citrate buffer and carbonate buffer. The amount of the buffer used is that amount sufficient to maintain the pH of the plating bath at a desired level, such amount being well known to those skilled in the art.

In a still further embodiment, an alloying metal may optionally be added to the plating bath. Any suitable alloying metal may be used. Such alloying metals are well known to those skilled in the art.

The present plating baths typically have a pH in the range of 7 to 14, more typically from 7 to 12, and still more typically from 9-12. The working temperature of the present plating baths is typically in the range of 10 to 30 °C. When the plating bath is a silver plating bath, the working temperature is typically in the range of 10 to 20 °C, and more typically from 15 to 20 °C. A chiller is typically used to maintain the plating bath at a temperature below room temperature.

The cyanide-free metal plating baths used in the present invention have sufficient stability under the conditions of illumination used in light assisted electroplating to provide metal deposits on photovoltaic devices that meet desired specifications. In addition, the present metal plating bath has ecological advantages over conventional light induced plating baths as the present plating bath is cyanide-free. A further advantage of the present invention is that high current outputs are also possible on the metal plated photovoltaic devices, so that the amount of energy used during the metal electroplating step can be reduced, thereby reducing the operating costs. A further advantage is that the present plating baths are sufficiently stable under the conditions of light induced plating to permit their use.

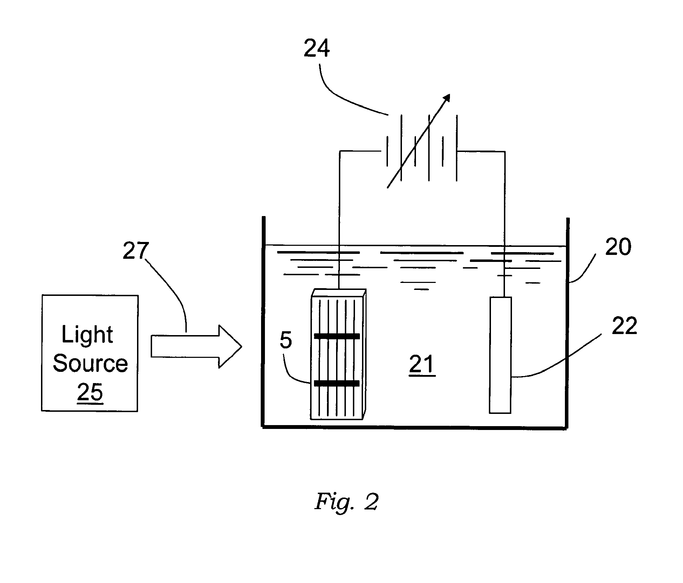

The patterned wafer 5 is now ready for thick layer of metal to be deposited on it. FIG. 2 schematically depicts a setup for light induced electroplating of a metal layer according to the invention. The patterned wafer 5, prepared as described above, is submerged in plating bath 21 contained in plating cell 20. Patterned wafer 5 is the cathode in the plating cell. The plating bath 21 is as described above. A light source 25 is positioned to illuminate wafer 5 with radiant energy generally indicated by the numeral 27. The positive terminal of power source 24 contacts silver anode 22 and the negative terminal contacts the back, or P side of wafer 5. If patterned wafer 5 is a silicon solar cell, light source 25 can be, for example, a quartz-halogen lamp which provides energy similar to that of the solar spectrum to which the silicon solar cell is photovoltaically sensitive. A variety of other light sources may be used, such as, but not limited to, incandescent lamps such as a 250 Watt lamp, and mercury lamps. The light energy 27 can be either continuous or pulsed. Pulsed illumination can be achieved, for example, by interrupting the light with a mechanical chopper.

Plating cell 20 must be of such a material as to be chemically inert with respect to the bath 21 and must also be transparent to light energy 27. Alternatively, the wafer can be positioned horizontally in plating cell 20 and illuminated from above the bath, in which case plating cell 20 need not be transparent. For plating silver on a single silicon wafer 5 as shown, a quartz beaker is a suitable plating cell 20. A silver anode 22 such as a silver sheet dissolves in the bath and keeps the bath saturated with silver as the plating proceeds.

By illuminating the front of wafer 5 with light energy 27 and by applying a potential to the plating cell from power supply 24, plating simultaneously occurs on the front and back of wafer 5. The applied potential may be continuous or pulsed. The impinging light energy generates a current in the solar cell. The rate of plating on the front side of wafer 5 is a function of the intensity of the radiation incident on the wafer since the generated current is proportional to the incident intensity. The rate of plating on the front and back surfaces are independently controllable by adjusting the light intensity and the external current density, respectively. A silver layer of 1 to 25 µm thickness is generally desired for a concentrator solar cell, with the exact thickness depending on various factors such as on the application, cell size, pattern geometry and the like.

The applied potential used in the present invention may have a range of current density. Typical current densities are from 0.1 A/dm² to 10 A/dm², and more typically from 0.1 A/dm² to 5 A/dm². The particular current requirement is dependent upon the particular size of the wafer used. If the front of the wafer is illuminated and the external potential is reduced to about 50 milliamperes or less, the plating continues normally on the front surface but no plating occurs on the rear of the wafer. Front illumination improves the uniformity of the rear plating and overcomes all of the difficulties associated with ohmic drops through the seed layer to points distant from the electrical contact. It will be appreciated by those skilled in the art that the present plating process may optionally include one or more reverse plating steps, such as a pulse periodic reverse plating process.

The above process has been described with particular reference to the plating of a layer of silver. The technique works equally well for plating other materials such as copper, gold or mixtures of tin and nickel. The mixtures of tin and nickel can be plated from an aqueous bath comprising stannous chloride, nickel chloride, ammonium hydroxide, and ammonium fluoride. The tin nickel mixtures have found use as an environmentally inert cap over other metal layers.

The above-described embodiments have been described with respect to silicon wafers used in solar cells, but the invention is not to be construed to such a limited usage. Photovoltaic devices fabricated from materials other than silicon can also be used, with appropriate changes where necessary, for example, in the source of light energy employed. The process does not work, however, in the absence of a photovoltaically responsive device. For example, when a silicon wafer containing a fired silver paste pattern is contacted with the present plating baths and subjected to a voltage of 0.5 volts with no irradiation, no to very little plating is observed. Also, placing a plain silicon wafer having no PN junction in the apparatus of FIG. 2 does not result in plating on the illuminated surface. When a silicon wafer containing a fired silver paste pattern is contacted with the present plating baths and subjected to actinic radiation with no applied voltage, very little plating is observed. However, when a silicon wafer containing a fired silver paste pattern is contacted with the present plating baths, and subjected to a voltage of 0.5 volts and subjected to irradiation, metal plating readily occurs.

The following examples are expected to illustrate various aspects of the invention.

### Example 1

A silver electroplating bath is prepared by combining the following components and adding sufficient deionized ("DI") water to make 1 liter of solution.

| | |
|---|---|
| 8 g/L silver as silver gluconate | 2 g/L m-nitrobenzene sulfonic acid |
| 10 g/L methane sulfonic acid solution (70%, neutralized with potassium hydroxide solution) | 25 g/L succinic acid amide |
| 4 g/L methionine | 1 mL/L TEGOTAIN 485 (1% aqueous solution) |
| 20 g/L borax | 0.1 mL/L sulfone derivative (1% aqueous solution) |
| 20 g/L succinic acid sulfamide | |

The pH of the plating bath is maintained in the range of 9 to 12. The temperature of the plating bath is maintained at 25 to 35 °C.

### Example 2

A silver electroplating bath is prepared by combining the following components and adding sufficient DI water to make 1 liter of solution.

| | |
|---|---|
| 9 g/L silver as silver methane sulfonate | 4 g/L 4-nitrophthalic acid |
| 15 g/L methane sulfonic acid solution (70%, neutralized with potassium hydroxide solution) | 15 g/L nicotinic acid amide |
| 10 g/L glycine | 5 mL/L TEGOTAIN 485 (1% aqueous solution) |
| 25 g/L borax | |

The pH of the plating bath is maintained in the range of 9.5 to 10.5. The temperature of the plating bath is maintained at 25 to 35 °C.

### Example 3

A silver electroplating bath is prepared by combining the following components and adding sufficient DI water to make 1 liter of solution.

| | |
|---|---|
| 10 g/L silver as silver methane sulfonate | 2 g/L 2-nitrophthalic acid |
| 5 g/L methane sulfonic acid solution (70%, neutralized with potassium hydroxide solution) | 25 g/L nicotinic acid amide |
| 5 g/L cysteine | 3 mL/L TEGOTAIN 485 (1% aqueous solution) |
| 20 g/L borax | 0.1 mL/L sulfone derivative (1% aqueous solution) |

The pH of the plating bath is maintained in the range of 9.5 to 10.5. The temperature of the plating bath is maintained at 25 to 35 °C.

### Example 4

The procedure of Example 1 is repeated except that methionine is replaced with an alkoxylated amino acid (an amino acid derivative).

### Example 5

A wafer as shown in FIG. 1 having a pattern of current collecting lines and busbars formed from fired silver paste is contacted with a 25% by volume aqueous methane sulfonic acid solution and then rinsed with DI water.

A plating cell containing a silver plating bath (ENLIGHT^{™} silver plate 600) and equipped with a 250 Watt lamp and a silver anode is provided. The patterned wafer is immersed in the plating bath. A current density of 1-5 A/dm² is applied with irradiation. Plating is continued for 30 minutes, after which time the light is wafer is removed from the plating bath, rinsed with DI water for 1 minute and then dried. An electrodeposited layer of silver having a thickness of 2-3 µm is obtained over the fired silver paste.

The plating bath is used over a period of 4-5 months to plate a number of wafers. The bath receives routine maintenance such as replenishment of depleted components, replacement of the anode and the like. No loss of bath stability is observed during this time period.

## Claims

1. A method of plating an electrical contact on a light-sensitive device displaying a photovoltaic effect, comprising providing a semiconductive wafer having at least two major surfaces, the wafer having a photovoltaic junction formed therein so that when one of the major surfaces of the wafer is exposed to light, negative charges collect at a first of the major surfaces and positive charges collect at a second of the major surfaces, contacting the wafer with a cyanide-free metal plating bath, applying a potential to the plating bath and exposing the wafer to light to deposit a layer of metal onto the first major surface, wherein the plating bath is an aqueous solution and comprises metal ions, at least one water-soluble nitro-containing compound, at least one surfactant, at least one amido-compound, and at least one component chosen from a water-soluble amino acid, a water-soluble sulfonic acid, and mixtures thereof.

2. The method of claim 1 further comprising the step of contacting the wafer with a solution comprising a sulfonic acid before contacting the wafer with the bath of cyanide-free silver electrolyte.

3. The method of claim 2 wherein the sulfonic acid is methane sulfonic acid.

4. The method of claim 1 wherein the light is continuous or pulsed.

5. The method of claim 1 wherein the wafer has an antireflective coating overlying the first major surface.

6. The method of claim 5 wherein the antireflective coating comprises one or more of a silicon oxide layer, a silicon nitride layer, and a combination of a silicon oxide layer and a silicon nitride layer.

7. The method of claim 1 wherein the bath further comprises a buffering agent and where the bath has a pH of 7 to 14.

8. The method of claim 1 wherein the metal is chosen from silver, gold and copper.

9. The method of claim 1 wherein the first major surface comprises a plurality of contacts.

10. The method of claim 1 further comprising providing a coating of the metal on the second major surface prior to contacting wafer with the cyanide-free metal plating bath.

11. The method of claim 1, wherein the plating bath further comprises one or more vitamins.
